## Europäisches Patentamt

## European Patent Office

## Office européen des brevets

(11) Numéro de publication : **0 004 242**
**B1**

(12) **FASCICULE DE BREVET EUROPÉEN**

(45) Date de publication du fascicule du brevet :
**22.06.83**

(21) Numéro de dépôt : **79400154.5**

(22) Date de dépôt : **09.03.79**

(51) Int. Cl.³ : **H 01 L 31/02**

(54) **Concentrateur de rayonnement solaire.**

(30) Priorité : **09.03.78 FR 7806850**

(43) Date de publication de la demande :
**19.09.79 Bulletin 79/19**

(45) Mention de la délivrance du brevet :
**22.06.83 Bulletin 83/25**

(84) Etats contractants désignés :
**BE CH DE GB IT LU NL SE**

(56) Documents cités :
**DE A 2 501 907**
**DE A 2 620 115**
**DE A 2 628 291**
**FR A 2 267 558**
**FR A 2 386 905**
**US A 3 990 914**
**US A 4 052 782**
**US A 4 127 425**
**APPLIED OPTICS, vol. 15, no. 10, octobre 1976
Washington W. H. WEBER et al. : « Luminescent
greenhouse collector for solar radiation » pages
2299-2300**
**RESEARCH DISCLOSURE no. 162, octobre 1977
Havant-Hants GB P. B. MAUER et al. : « Fluorescent solar energy concentrator » pages 43-44**

(73) Titulaire : **Gravisse, Philippe**
**18 - 20, rue de Presles**
**F-75015 Paris (FR)**

(72) Inventeur : **Gravisse, Philippe**
**18 - 20, rue de Presles**
**F-75015 Paris (FR)**

(74) Mandataire : **Bugnon-Hays, Claudine et al**
**PATCO S.A. 45, Boulevard Albin Durand**
**F-84200 Carpentras (FR)**

Jouve, 18, rue St-Denis, 75001 Paris, France

Concentrateur de rayonnement solaire

La présente invention concerne un dispositif concentrateur de rayonnement, notamment solaire, comportant une enceinte dont au moins l'une des faces principales $V_1$, $V_2$ est transparente au rayonnement incident, à l'intérieur de laquelle est disposée, parallèlement auxdites faces principales, une matrice lumineuse dans laquelle sont disposés des agents luminescents susceptibles d'absorber le rayonnement incident et de le réémettre successivement, avec une longueur d'onde supérieure sous forme de cascade lumineuse, de manière à ce que la longueur $\lambda 2$ du rayonnement final, corresponde à la zone de sensibilité optimale de la ou des photopiles disposées sur une ou plusieurs des faces latérales de l'enceinte et dont la surface est petite par rapport auxdites surfaces principales.

De tels dispositifs sont connus et par exemple, décrits dans le brevet US n° 4 127 425 et le brevet allemand n° 2 628 291.

Le fascicule de brevet US-A-4 127 425 décrit un dispositif collecteur de rayonnement se composant (voir figure 1) d'une couche plane luminescente (10) et d'une cellule solaire (14) disposée sur une des faces latérales. La couche (10) est constituée par une matrice dans laquelle un ou plusieurs agents luminescents sont répartis. Les autres faces latérales et la face inférieure peuvent être recouvertes de miroirs. Un rayonnement incident à la face supérieure (24) est absorbé et réémis dans un angle de $4\pi$. Par réflection internes successives, un flux intense de lumière de la longueur d'onde désirée est alors canalisé vers l'extrémité recouverte par la cellule. Les couches planes luminescentes (10) peuvent être constituées de verre ou d'un matériau polymère dans lequel des agents luminescents sont dispersés. Ces agents peuvent émettre directement la lumière dont l'énergie est voisine de la gamme à laquelle la cellule photovoltaïque est sensible ; ils peuvent également émettre celle-ci au moyen d'un phénomène de cascade.

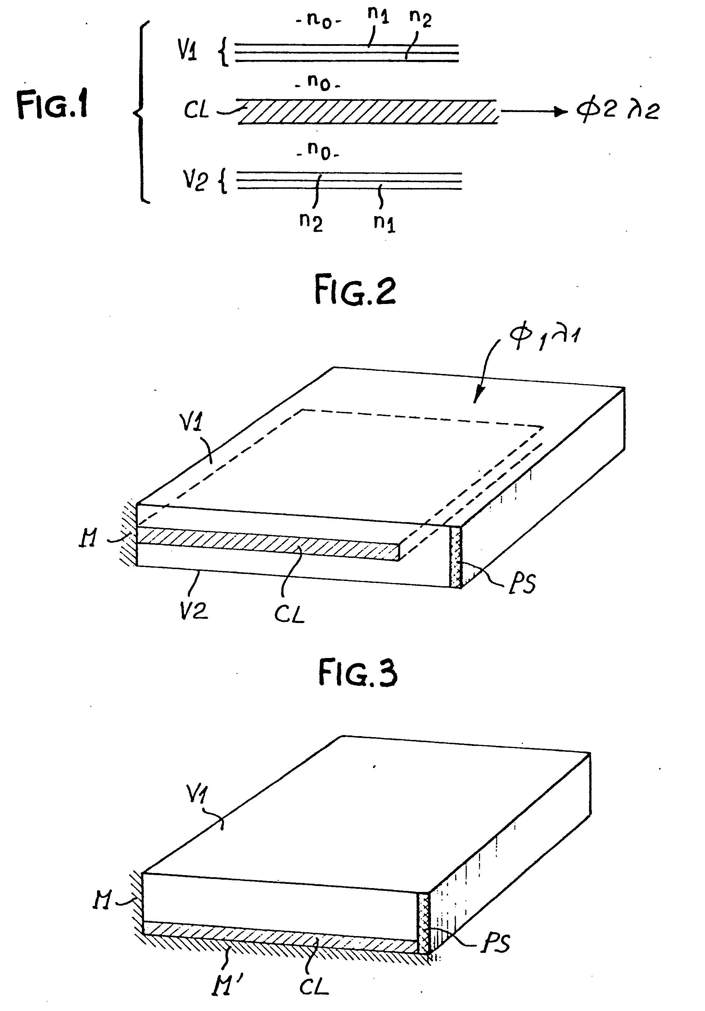

Le fascicule de brevet DE-A-2 628 291 décrit également un collecteur de rayonnement permettant la concentration et le changement de longueur d'onde. Selon une des réalisations proposées (voir revendication 14 et figures 1 et 3), ce collecteur comporte un concentrateur ayant la forme d'une cuvette plane et renfermant un solvant avec des agents fluorescents. On sélectionne des substances telles que la bande d'émission de l'une $(e_1)$ couvre la bande d'absorption de l'autre $(a_2)$. On a alors un fonctionnement en cascade lumineuse : absorption $(a_1)$-émission $(e_2)$. D'autres formes de réalisation proposent des cascades disposées dans des couches superposées.

La technique antérieure (demande de brevet français 73 21890) connaît également un dispositif photovoltaïque constitué par une photopile du type diode à jonction de grande surface, revêtue d'une pluralité de couches disposées les unes sur les autres et réalisées en une matière transparente au spectre de sensibilité de la photopile, ladite matière étant préférentiellement une résine aux silicones ; ce dispositif est notamment remarquable en ce que chaque couche contient un hydrocarbure aromatique apte à récupérer l'énergie provenant de la couche précédente et à la transmettre à la couche suivante, la photopile recevant ainsi cumulativement les énergies des diverses couches.

Le dispositif amplificateur d'énergie rayonnante décrit dans la demande de brevet français 76 09321 est adaptable à une photopile ou autre capteur qui reçoit des énergies provenant des faibles longueurs d'onde par l'intermédiaire d'une pluralité d'hydrocarbures aromatiques ou autres substances luminescentes à rendement quantique élevé fonctionnant en cascade ; ce dispositif est notamment remarquable en ce que sur ladite photopile ou ledit capteur est disposée une matrice monocouche, réalisée en matière synthétique à l'intérieur de laquelle sont dispersés de façon homogène les divers hydrocarbures ou autres substances luminescentes à rendement quantique élevé, ladite matière synthétique étant choisie de telle sorte que son seuil d'absorption se situe à une longueur d'onde inférieure à la zone d'absorption de l'hydrocarbure ou de la substance fluorescente placé en début de cascade, c'est-à-dire vers les plus faibles longueurs d'onde.

De plus, dans l'article de E. WEBER et J. LAMBE publié dans « Applied Optics » volume 15, n° 10 pages 2299-2300 est décrit un collecteur de rayonnement disposé dans une enceinte dont la surface supérieure est une fenêtre en verre ou en plastique et la surface inférieure est un miroir.

Dans tous ces dispositifs de la technique antérieure, la réémission se présente sous forme d'un rayonnement radiatif aléatoire diffus et une partie de ce rayonnement ressort du collecteur par sa face supérieure exposée au rayonnement solaire.

Le pourcentage de lumière réémise réfléchie totalement par cette surface est fonction de l'indice de réfraction n de la matrice et croît avec celui-ci.

Par exemple, pour une matrice d'un indice 1,5, la lumière réémise réfléchie présente 75 % de la réémission.

On constate alors que 25 % de la lumière réémise sort par les faces avant et arrière de l'enceinte ce qui constitue un inconvénient majeur.

L'homme de l'art tendra, par conséquent, à utiliser une matrice présentant un indice n aussi élevé que possible.

Mais dans ce cas, les pertes à l'entrée par réflexion augmentent considérablement.

En effet, en incidence normale :

$$= (n - 1)^2/(n + 1)^2$$

pour $n = 1,5$ on obtient alors $= 0,04$ et
pour $n = 1,3$ on obtient $= 0,017$.

Ceci démontre clairement l'influence de n sur la lumière réfléchie à l'entrée.

D'autres solutions utilisées par la technique antérieure, par exemple une surface crantée de la matrice, présentent les mêmes inconvénients et augmentent considérablement la réflexion de la lumière solaire incidente.

L'invention a pour objet de concevoir un dispositif concentrateur dudit type permettant de remédier à cet inconvénient dans lequel les pertes de lumière réémise sont réduites sans augmentation de la réflexion de la lumière incidente.

Dans le dispositif selon l'invention, ladite au moins une des faces principales transparentes est constituée de deux couches d'indices n1 et n2, la couche d'indice n2 où n2 est aussi grand que possible par rapport à n1, étant située du côté faisant face à ladite matrice lumineuse.

Ces couches permettent de diminuer la réflexion de la lumière incidente et d'augmenter en même temps la réflexion de la lumière réémise avec changement de longueur d'onde.

Dans la pratique, la structure selon l'invention permet d'obtenir une amélioration du rendement global du concentrateur d'environ 10 %. Une telle amélioration est considérable dans la technique des collecteurs de rayonnement solaire.

Suivant un mode de réalisation avantageux du dispositif concentrateur selon l'invention, au moins une des faces latérales de l'enceinte est constituée d'un miroir dont la face réfléchissante est tournée vers l'intérieur de l'enceinte.

On augmente ainsi la réflexion à l'intérieur de l'enceinte et améliore le rendement de la ou des photopiles.

Suivant un mode de réalisation préféré, l'enceinte est telle que lesdites faces principales ($V_1$, $V_2$) sont de forme polygonale.

Suivant un autre mode de réalisation du dispositif selon l'invention seules les petites faces latérales sont occupées par les photopiles.

Suivant une variante selon l'invention, lesdites surfaces principales sont de forme hexagonale.

Enfin, suivant un mode de réalisation particulier du concentrateur selon l'invention, l'enceinte présente une forme tubulaire.

D'autres réalisations et avantages de l'invention ressortiront de la description qui va suivre et en se référant aux dessins annexés montrant à titre d'exemple plusieurs modes de réalisation du dispositif concentrateur selon l'invention.

Sur ces dessins :

la figure 1 représente le schéma de fonctionnement du dispositif selon un mode de réalisation de l'invention ;

la figure 2 est une vue en perspective du dispositif de la figure 1 ;

la figure 3 est une variante d'exécution du dispositif de la figure 2 ;

la figure 4 est une deuxième variante d'exécution du dispositif de la figure 2 ;

la figure 5 est une vue en perspective d'une autre variante d'exécution du dispositif selon la présente invention ;

la figure 6 est une vue en coupe du dispositif de la figure 5, dans un mode de réalisation particulier.

Référence étant maintenant faite à la figure 1, on notera que le principe de fonctionnement du dispositif est le suivant :

Le rayonnement $\phi 1$ de longueur d'onde $\lambda 1$, qui est un rayonnement dirigé, vient frapper la paroi V1 d'une enceinte à l'intérieur de laquelle se trouve la cascade lumineuse CL ; cette paroi V1 présente selon l'invention un double indice de réfraction, à savoir un indice n1 du côté de l'extérieur de ladite enceinte et un indice n2 du côté de l'intérieur de cette enceinte. D'une façon générale, un indice $n_0$, correspondant à l'air, règne à l'intérieur et à l'extérieur de ladite enceinte ; la cascade lumineuse dans la présente description et dans les revendications, doit être comprise comme étant une substance solide ou liquide dans laquelle sont dispersés des éléments luminescents puisant de l'énergie dans les faibles longueurs d'onde et la réémettant dans des longueurs d'onde supérieures $\lambda 2$ correspondant à la zone d'efficacité optimale de la photopile, non représentée ici, mais située en regard de la tranche de la cascade lumineuse, c'est-à-dire dans le cas de la figure 1, perpendiculairement à la paroi V1.

On passe ainsi d'un rayonnement $\phi 1 \lambda 1$, dirigé, à rayons parallèles à un rayonnement $\phi \lambda 2$, réémis de façon isotropique dans un angle de $4\pi$. Grâce à l'indice n2 supérieur à l'indice n1, le rayonnement $\phi 2 \lambda 2$ ne pourra pratiquement pas retraverser la paroi V1, d'où une concentration d'énergie à l'intérieur de l'enceinte ; une paroi V2 identique à V1 peut avantageusement être placée de l'autre côté de la cascade lumineuse.

Les parois V1 et V2 peuvent être réalisées en verre ordinaire hautement transparent d'indice de réfraction n1 = 1,5, muni d'une couche mince d'indice de réfraction n2 plus élevé, 2,25 par exemple. De plus, on pourra avantageusement recouvrir extérieurement la paroi V1, d'une couche anti reflet d'indice n'1 permettant ainsi à un maximum de rayonnement de pénétrer dans l'enceinte. Les figures 2 à 6 illustrent mieux le concentrateur selon l'invention qui présente une géométrie prismatique, la hauteur de chacun des prismes étant faible par rapport aux dimensions des bases.

Dans la figure 2, lesdites bases sont des rectangles et sont constituées des parois V1 et V2 ; l'une des faces latérales est constituée d'un miroir M, la face opposée comprenant une ou plusieurs photopiles disposées en regard dudit miroir M. Ce dernier dont la face réfléchissante est tournée vers l'intérieur de l'enceinte augmente les réflexions à l'intérieur de ladite enceinte et améliore le rendement de la ou des photopiles ; les deux faces latérales restantes peuvent être soit des parois du type V1 ou V2, soit des miroirs du type du miroir M.

En outre, la cascade lumineuse CL est ici solide et vient buter contre la photopile PS ; il est également possible soit d'écarter de la photopile l'extrémité de ladite cascade lumineuse, soit d'élargir celle-ci de façon à ce que sa section transversale corresponde, en dimensions, à la photopile PS.

La figure 3 est une variante du concentrateur de la figure 2 et l'on remarque que seule l'une des bases est constituée d'une paroi à double indice de réfraction (du type V1) ; l'autre base est constituée d'un miroir M' tourné de la même façon que le miroir M, vers l'intérieur de l'enceinte ; dans le cas de la figure 3, la cascade lumineuse est accolée au miroir M'. Cette dernière caractéristique n'est pas indispensable.

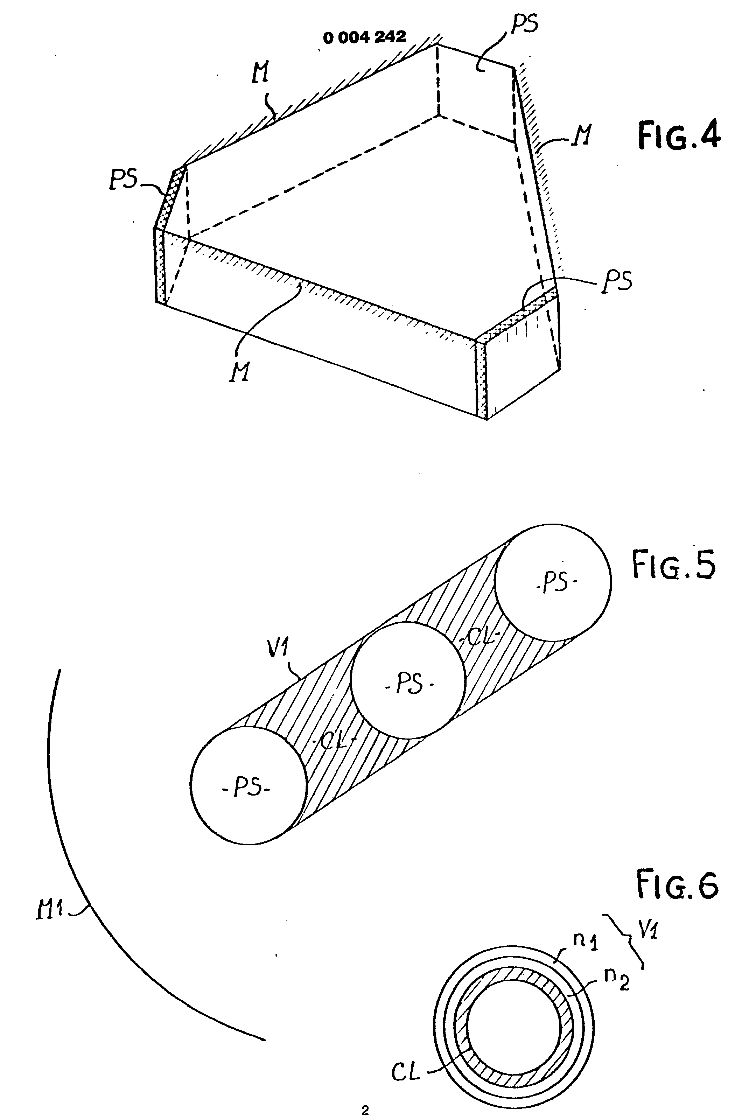

La figure 4 représente une autre variante où les bases sont triangulaires, les trois faces latérales étant constituées de miroirs M et une photopile PS étant prévue à chaque arête du prisme, de telle sorte qu'il y a toujours un miroir M face à une photopile PS. Dans ce cas de figure, l'une des bases est constituée d'une paroi du type V1, l'autre base étant soit du type V2, soit un miroir M' comme précédemment décrit.

Le concentrateur représenté à la figure 2 peut par exemple servir de vitrage ; la quantité de lumière traversant l'enceinte, quoique faible en raison des indices n1 et n2 des parois V1 et V2 est tout de même suffisante pour assurer un appoint d'éclairage dans un local qui comprendrait un tel concentrateur comme vitrage. De plus, ce dernier étant double (parois V1 et V2), on retrouverait les avantages classiques des doubles vitrages (isolations thermique et phonique notamment).

Par ailleurs, des avantages certains apparaissent au niveau des photopiles dans ces concentrateurs ; en premier lieu, lesdites photopiles peuvent être, à courant égal, réduites en nombre puisque le rendement du présent concentrateur est amélioré par rapport aux concentrateurs classiques simples. En outre, ces concentrateurs étant éventuellement destinés à servir de panneaux externes pour des bâtiments, les photopiles se trouvant sur les parois latérales sont protégées.

C'est pourquoi pour réaliser de tels panneaux, on utilisera préférentiellement des concentrateurs présentant la géométrie telle qu'illustrée dans les figures 2 à 4, c'est-à-dire celle d'un prisme plat.

Une autre géométrie peut être utilisée dans une autre application du concentrateur selon l'invention.

Cette géométrie apparaît dans les figures 5 et 6 où l'enceinte est cylindrique, le concentrateur ayant alors la forme d'un tube.

La figure 5 illustre un mode de réalisation où les photopiles sont disposées normalement à l'axe longitudinal du cylindre et tournées vers l'intérieur du tube. Dans cette figure, on peut utiliser soit une cascade lumineuse liquide, avec bouche thermodynamique, soit une cascade lumineuse solide occupant tout l'intérieur du tube, soit encore, c'est le cas illustré à la figure 6, une cascade lumineuse solide CL se présentant sous forme d'une couche disposée à l'intérieur de l'enceinte contre la paroi V1, l'intérieur dudit tube étant rempli d'air ou d'un gaz rare ou non. Une autre variante consiste à prendre un tube à double indice n1, n2, la cascade lumineuse solide se présentant sous forme de couche recouvrant seulement les photopiles.

Quel que soit le mode de réalisation illustré, on retrouve toujours l'enceinte à l'intérieur de laquelle se trouve une cascade lumineuse, ladite enceinte présentant au moins une face principale constituée d'une paroi en verre ou analogue à double indice de réfraction ; il est bien entendu que la présente invention couvre également le cas de la cascade lumineuse CL solide recouverte d'un revêtement transparent d'indice n2, lui-même recouvert d'un revêtement transparent d'indice n1.

De même, les photopiles utilisables sont essentiellement au silicium, de type unijonction, mais on peut utiliser dans le présent concentrateur d'autres photopiles de type multijonction ou au cas, GaAs, voire même le silicium amorphe.

## Revendications

1. Dispositif concentrateur de rayonnement, notamment solaire, comportant une enceinte dont au moins l'une des faces principales ($V_1$, $V_2$) est transparente au rayonnement incident ($\phi 1$, $\lambda 1$) à l'intérieur de laquelle est disposée, parallèlement auxdites faces principales, une matrice lumineuse dans laquelle sont disposés des agents luminescents susceptibles d'absorber le rayonnement incident et de le réémettre successivement, avec une longueur d'onde supérieure sous forme de cascade lumineuse, de manière à ce que la longueur d'onde ($\lambda 2$) du rayonnement final, corresponde à la zone de sensibilité optimale de la ou des photopiles disposées sur une ou plusieurs des faces latérales de l'enceinte et dont la surface est petite par rapport auxdites surfaces principales, caractérisé en ce que ladite au moins une des faces principales transparentes est constituée de deux couches d'indices n1 et n2, la couche d'indice n2 où n2 est aussi grand que possible par rapport à n1, étant située du côté faisant face à ladite matrice lumineuse.

2. Dispositif concentrateur selon la revendication 1, caractérisé en ce qu'au moins une des faces latérales de l'enceinte est constituée d'un miroir dont la face réfléchissante est tournée vers l'intérieur de l'enceinte.

3. Dispositif concentrateur selon les revendications 1 ou 2, caractérisé en ce que l'enceinte est telle que lesdites faces principales ($V_1$, $V_2$) sont de forme polygonale.

4. Dispositif concentrateur selon l'une des revendications 1 à 3 caractérisé en ce que seules les petites faces latérales sont occupées par les photopiles.

5. Dispositif concentrateur selon la revendication 3 caractérisé en ce que lesdites surfaces principales sont de forme hexagonale.

6. Dispositif concentrateur selon la revendication 1 caractérisé en ce que l'enceinte présente une forme tubulaire.

## Claims

1. Concentrator device for radiation, especially solar radiation, comprising an enclosure, at least one of whose main faces ($V_1$, $V_2$) is transparent to incident radiation ($\phi 1$, $\lambda 1$), at the inside of which there is provided, parallel to said main faces, a luminous matrix in which luminescent agents are provided which are susceptible to absorb the incident radiation and to re-emit it successively with an upper wavelength in the form of a light cascade, in such a manner that the wavelength ($\lambda 2$) of the final radiation corresponds to the zone of optimum sensibility of the photopile or the photopiles arranged on one or several lateral faces of the enclosures and whose surface is small with respect to said main faces, characterized in that the said, at least one transparent main face is formed of two layers with indexes $n_1$ and $n_2$, with the layer having the index $n_2$, where $n_2$ is as great as possible with respect to $n_1$, being positioned at the side facing said luminous matrix.

2. Concentrator device according to claim 1, characterized in that at least one of the lateral faces or the enclosure is formed of a mirror whose reflecting face is turned toward the inside of the enclosure.

3. Concentrator device according to claims 1 or 2, characterized in that the enclosure is such that said main faces ($V_1$, $V_2$) are of polygonal shape.

4. Concentrator device according to one of claims 1 to 3, characterized in that the photopiles are provided only on the small lateral faces.

5. Concentrator device according to claim 3, characterized in that said main faces are of hexagonal shape.

6. Concentrator device according to claim 1, characterized in that the enclosure is of tubular shape.

## Ansprüche

1. Strahlungskonzentrator, insbes. für Sonnenbestrahlung, der ein Gehäuse einschliesst, wovon mindestens eine Hauptfläche ($V_1$, $V_2$) durchlässig ist für einfallend Bestrahlung ($\phi 1$, $\lambda 1$), an dessen Innenseite, parallel zu den Hauptseiten, eine leuchtende Matrize vorgesehen ist, in der lichtausstrahlende Substanzen angeordnet sind, die geeignet sind, einfallende Strahlen zu absorbieren und nacheinander wieder auszustrahlen mit eine grösseren Wellenlänge in Form einer Lichtkaskade auf solche Weise, dass die Wellenlänge (2) der letzten Bestrahlung der Zone der höchsten Empfindlichkeit der Photozelle oder der Photozellen entspricht, die auf einer oder mehreren Seiten des Gehäuses angeordnet ist und deren Oberfläche klein ist im Verhältnis zu den Hauptflächen, dadurch gekennzeichnet, dass die genannte, mindestens eine durchlässige Hauptfläche aus zwei Schichten mit Brechungsindexen $n_1$ und $n_2$ besteht, wobei die Schicht mit dem Index $n_2$, wo $n_2$ so gross wie möglich ist im Verhältnis zu $n_1$, auf der Seite gelegen ist, die der genannten leuchtenden Matrize zugewandt ist.

2. Strahlungskonzentrator gemäss Anspruch 1, dadurch gekennzeichnet, dass mindestens eine der setlichen Flächen des Gehäuses aus einem Spiegel besteht, dessen reflektierende Seite nach der Innenseite des Gehäuses gewandt ist.

3. Strahlungskonzentrator gemäss Anspruch 1 oder 2, dadurch gekennzeichnet, dass das Gehäuse so geartet ist, dass die genannten Hauptflächen ($V_1$, $V_2$) polygonal geformt sind.

4. Strahlungskonzentrator gemäss einem der Ansprüche 1 bis, 3, dadurch gekennzeichnet, dass die Photozellen nur auf den kleinen Seitenflächen angeordnet sind.

5. Strahlungskonzentrator gemäss Anspruch 3, dadurch gekennzeichnet, dass die genannten Hauptflächen hexagonal sind.

6. Strahlungskonzentrator gemäss Anspruch 1, dadurch gekennzeichnet dass das Gehäuse rohrförmig ist.

**FIG.1**

$V_1$ { $-n_0-$ $n_1$ $n_2$

$CL$ $-n_0-$ $\longrightarrow \phi_2\lambda_2$

$V_2$ { $-n_0-$ $n_2$ $n_1$

**FIG.2**

$\phi_1\lambda_1$

$V_1$

$M$

$V_2$ $CL$ $PS$

**FIG.3**

$V_1$

$M$

$M'$ $CL$ $PS$

0 004 242

FIG.4

FIG.5

FIG.6

2